# EUROPEAN PATENT SPECIFICATION

(11) **EP 2 708 936 B1**
(45) Date of publication and mention of the grant of the patent: **07.07.2021**
(21) Application number: 12785276.2
(22) Date of filing: 08.05.2012
(51) Int. Cl.: G02B 27/22, G09G 5/10, H01L 25/075, H01L 33/58, G02B 19/00, H04N 13/305

(54) **LARGE 3D SCREEN BASED ON LIGHT TUBES WITH CYLINDRICAL LENS**
GROSSER 3D-BILDSCHIRM MT LEUCHTRÖHREN MIT ZYLINDRISCHEN LINSEN
ÉCRAN 3D LARGE COMPRENANT DES TUBES ÉLECTROLUMINESCENTS À LENTILLE CYLINDRIQUE

(30) Priority: 13.05.2011 CN 201120151626 U; 13.05.2011 CN 201110122809
(43) Date of publication of application: 19.03.2014
(73) Proprietor: Li, Chao, Henan 450001 (CN)
(72) Inventor: LI, Chao, Zhengzhou Henan 450001 (CN); SHI, Daxin, Zhengzhou Henan 450001 (CN); KANG, Xianbin, Zhengzhou Henan 450001 (CN); XIONG, Bin, Zhengzhou Henan 450001 (CN); LI, Shuzheng, Zhengzhou Henan 450001 (CN)
(74) Representative: Lang, Christian
(86) International application number: PCT/CN2012/075205
(87) International publication number: WO 2012/155800

(56) References cited:
- WO-A1-2011/006835
- CN-A- 101 546 500
- CN-A- 102 183 845
- CN-U- 202 049 292
- JP-A- 2004 020 684
- JP-A- 2005 326 610
- US-A- 5 528 420
- US-A1- 2002 075 566
- US-A1- 2003 016 444
- US-B2- 7 820 954

## Description

The invention relates to an LED stereoscopic screen, and more particularly to a large LED stereoscopic screen comprising a cylindrical lens.

For conventional stereoscopic shutter glasses, images perceived by the left eye and the right eye switch fast, resulting in serious visual flashes and visual fatigue. Besides, the stereoscopic display and the flat panel display are not completely compatible with each other. For the liquid crystal or the plasma display screen, a cylindrical lens can be arranged in front of the display screen for realizing naked-eye stereoscopic display. When the principal is directly applied to the large LED stereoscopic screen, a cylindrical-like lens plate is required to be arranged in front of the large LED stereoscopic screen, which causes a large decrease of the contrast and saturation of the display due to a serious reflection produced on the lens plate. WO 2011/006835 A1 recites a display that includes a plurality of light-emitting components, and each of the light-emitting components contains a lens and a plurality of light-emitting diodes.

It is one objective of the invention to provide a large stereoscopic screen based on a light-emitting tube provided with a cylindrical lens. The large stereoscopic screen of the invention overcomes drawbacks in the prior art by arranging a cylindrical lens on one side of a light-emitting point or a light-emitting pixel, allowing the screen comprising the light-emitting points or the light-emitting pixels to transmit light of a left image and a right image to the left eye and the right eye, respectively, to form a difference between visual images perceived by the left eye and the right eye in correspondence with the light-emitting principal of the cylindrical lens, and finally resulting in a stereoscopic image in the human brain. People are not required to wear a pair of stereoscopic glasses so that the naked-eye stereoscopic large screen display is realized.

To achieve the above objective, the invention employs the technical features of claim 1.

A large stereoscopic screen based on a light-emitting tube provided with a cylindrical lens, the large stereoscopic screen comprises: a control device, and a display screen. The display screen comprises a plurality of light-emitting pixels controlled by the control device. Each of the light-emitting pixels is provided with the cylindrical lens, respectively, to form a difference between visual images perceived by a left eye and a right eye according to a light-emitting principle of the cylindrical lens.

As an improvement the light-emitting pixel is the light-emitting tube comprising the cylindrical lens, a capsule, a pin, and a light-emitting chip. The light-emitting chip is disposed inside the capsule, the cylindrical lens is disposed on the capsule, and the pin is connected to the light-emitting chip. A cylindrical surface of the cylindrical lens of the light-emitting pixel is straight, convex, or concave. The light-emitting pixel comprises two light-emitting chips; one of the light-emitting chips operates to display image information for the left eye, and the other operates to display image information for the right eye. The light-emitting pixel is divided into two bilaterally symmetrical parts for displaying the image information for the left eye and the image information for the right eye, respectively. The light-emitting pixel comprises a light-emitting pixel for displaying the image information for the left eye and a light-emitting pixel for displaying the image information for the right eye; and both the light-emitting pixels for displaying the image information for the left eye and the right eye comprise three-primary colors (RGB). The light-emitting pixel is divided into two bilaterally symmetrical parts for displaying the image information for the left eye and the image information for the right eye, respectively.

The light-emitting pixel employs the light-emitting tube or the SMD, both of which have a cylindrical lens, or the cylindrical cover is arranged on the light-emitting surface of the capsule of the SMD. The light-emitting tube is monochromatic light-emitting (one color of RGB), and the SMD is the monochromatic light-emitting or three-primary colors light-emitting (three colors of RGB). The light-emitting chips of the light-emitting tube and the SMD are able to synchronously display the image information for the left eye and the right eye. The arrangement of the cylindrical lens or the cylindrical cover forms the difference between visual images perceived by the left eye and the right eye in correspondence with the light-emitting principal of the cylindrical lens, and finally results in a stereoscopic image in the human brain. People are not required to wear a pair of stereoscopic glasses so that the naked-eye stereoscopic large screen display is realized.

Furthermore, the arrangement of the cylindrical lens or the cylindrical cover on the light-emitting pixel solves the problem of the large LED stereoscopic screen in the prior art that the cylindrical-like lens plate is necessitated to be arranged in front of the large LED stereoscopic screen, which causes a large decrease of the contrast and saturation of the display due to a serious reflection produced on the lens plate. The light-emitting pixel or the light-emitting point is able to form a high-definition displaying complete pixel, so that the resolution, contrast, and saturation of the system do not decrease, the stereoscopic display and the flat panel display are compatible. The operation is simple and the definition is high.

Advantages of a stereoscopic screen are summarized as follows:
The cylindrical lens is arranged on the light-emitting point or the light-emitting pixel, and the large screen comprising the light-emitting points or the light-emitting pixels is allowed to transmit light of the left image and the right image to the left eye and the right eye, respectively, to form the difference between visual images perceived by the left eye and the right eye in correspondence with the light-emitting principal of the cylindrical lens, resulting in a stereoscopic image in the human brain. People are not required to wear a pair of stereoscopic glasses so that the naked-eye stereoscopic large screen display is realized. A periphery of each light-emitting point or each light-emitting pixel is treated by different kinds of black matrix, including but not limited to, a black plastic frame, for increasing the contrast and the color saturation.

The light-emitting pixel of the invention is able to synchronously display the visual images for the left eye and the right eye to form a high-definition displaying complete pixel, so that the resolution, the contrast, the color saturation of the system will not decrease, the stereoscopic display and the flat panel display are compatible. The operation is simple and the definition is high.

Other advantages, objectives, and features will be described in the following description to a certain degree, it is obvious for ordinary skill in the art to study the following description or learn from the practice of the disclosed examples. The objectives and advantages of the invention are described in the following description or can be realized by the structures indicated in the drawings.
FIG. 1 is a basic schematic diagram of a stereoscopic display for a conventional liquid crystal cylindrical lens;
FIG. 2 is a diagram of a cylindrical lens plate;
FIG. 3 is a diagram of a light-emitting tube provided with a cylindrical lens taken from a cylindrical lens plate;
FIG. 4 is a diagram of a light-emitting tube provided with a cylindrical lens having a side in a longitudinal section being a straight line;
FIG. 5 is a diagram of a light-emitting tube provided with a cylindrical lens having a side being a convex line;
FIG. 6 is a diagram of a light-emitting tube provided with a cylindrical lens having a side being a concave line;
FIG. 7 is a diagram of a basic shape of a light-emitting tube provided with an ellipsoid lens;
FIG. 8 is a diagram of a basic shape of a light-emitting tube provided with a spherical lens;
FIG. 9 is a diagram of a light-emitting tube having four pins, in which two secondary pins are arranged in a middle;
FIG. 10 is a top view of a light-emitting tube of FIG. 9;
FIG. 11 is a diagram of a light-emitting tube having three pins, in which a secondary pin is arranged in a middle;
FIG. 12 is a top view of a light-emitting tube of FIG. 11;
FIG. 13 is a diagram of a light-emitting tube having four pins, in which two secondary pins are arranged in periphery;
FIG. 14 is a top view of a light-emitting tube of FIG. 13;
FIG. 15 is a diagram of a light-emitting tube having three pins, in which two secondary pins are arranged in periphery;
FIG. 16 is a top view of a light-emitting tube of FIG. 15;
FIG. 17 is a diagram of an arrangement of circuit boards of the light-emitting tube;
FIG. 18 is a diagram of circuit boards of the light-emitting tube arranged in a high density;
FIG. 19 is a diagram showing a half part of a light-emitting tube having a secondary pin arranged in a middle;
FIG. 20 is a diagram showing a half part of a light-emitting tube having a secondary pin arranged in periphery;
FIG. 21 is an assembly diagram of two half parts of a light-emitting tube provided with a cylindrical lens on a circuit board;
FIG. 22 is an assembly diagram of six half parts of a light-emitting tube on a circuit board;
FIG. 23 is a diagram of two three-in-one SMD light-emitting pixels of a cylindrical lens being assembled together and further enclosed by the cylindrical lens based on an original enclosed structure;
FIG. 24 is a top view of a cylindrical lens of FIG. 23;
FIG. 25 is a diagram of two three-in-one SMD light-emitting pixels of a cylindrical lens being assembled together and light-emitting chips are directly enclosed by the cylindrical lens;
FIG. 26 is a top view of a cylindrical lens of FIG. 25;
FIG. 27 is a diagram of an individual three-in-one SMD light-emitting pixel of a cylindrical lens after a secondary package;
FIG. 28 is a top view of a cylindrical lens of FIG. 27;
FIG. 29 is a diagram of an individual three-in-one SMD light-emitting pixel of a cylindrical lens being directly enclosed;
FIG. 30 is a top view of a cylindrical lens of FIG. 29;
FIG. 31 is a diagram of two individual three-in-one SMD light-emitting pixels of a cylindrical lens being mounted on a circuit board;
FIG. 32 is a top view of a cylindrical lens of FIG. 31;
FIG. 33 is a diagram of two single-colored SMD light-emitting tubes of a cylindrical lens being assembled together;
FIG. 34 is a top view of a cylindrical lens of FIG. 33;
FIG. 35 is a diagram of an individual SMD light-emitting tube of a cylindrical lens;
FIG. 36 is a top view of a cylindrical lens of FIG. 35;
FIG. 37 is a diagram of two individual single-colored SMD light-emitting tube assembled on a circuit board; and
FIG. 38 is a top view of a light-emitting tube of FIG. 37.

### Best mode of the invention

The large stereoscopic screen comprises a control device and a display screen. The display screen comprises a plurality of light-emitting pixels (also called light-emitting points) controlled by the control device. Each of the light-emitting pixels is provided with the cylindrical lens, respectively. The large screen comprising such light-emitting pixels emits light of right visual image and left visual image perceived by the right eye and the left eye, respectively, to form a difference between visual images perceived by the left eye and the right eye according to the light-emitting principle of the cylindrical lens, and finally form a stereoscopic image in human brain. People are not required to wear a pair of stereoscopic glasses so that the naked-eye stereoscopic large screen display is realized. A periphery of each light-emitting point or each light-emitting pixel is treated by different kinds of black matrix, including but not limited to, a black plastic frame, for increasing the contrast and the color saturation.

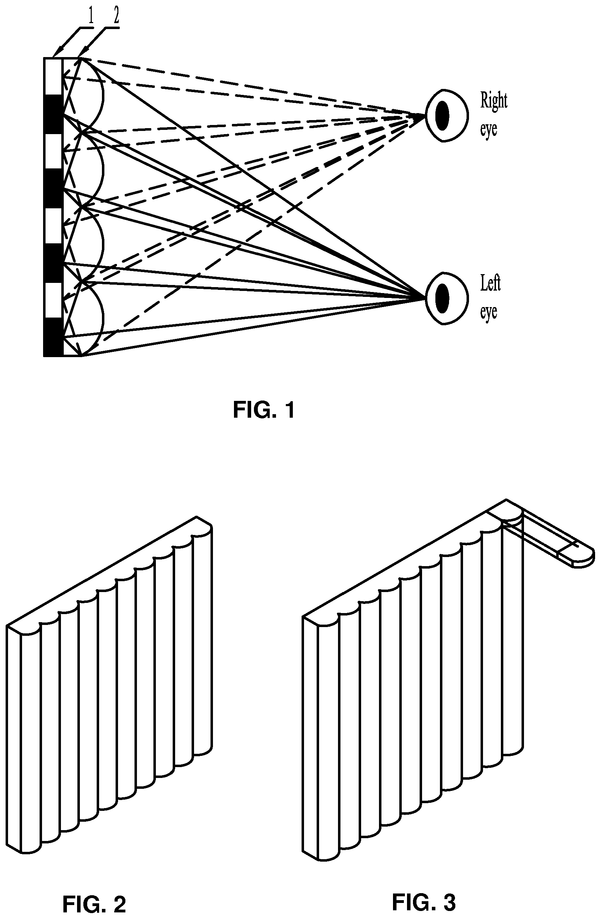

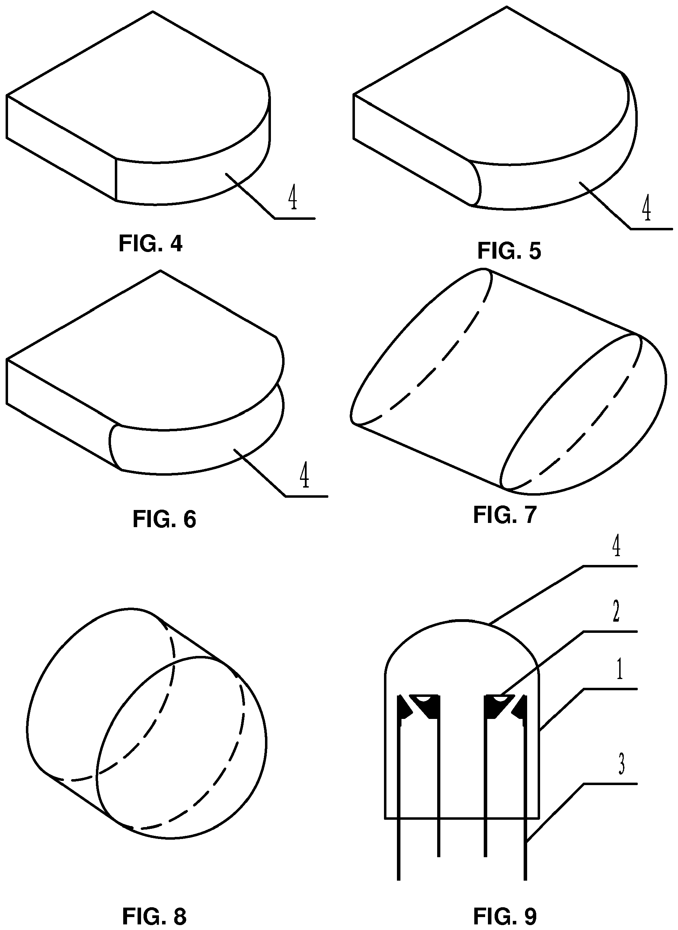

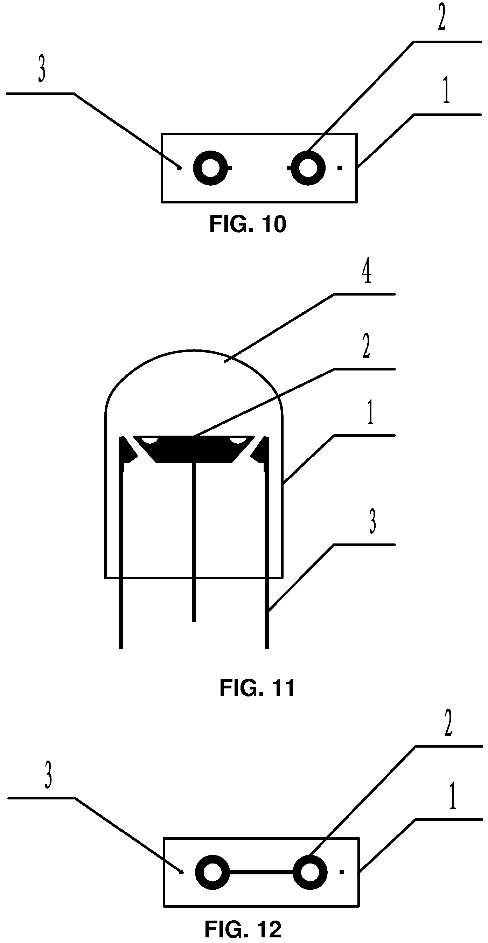

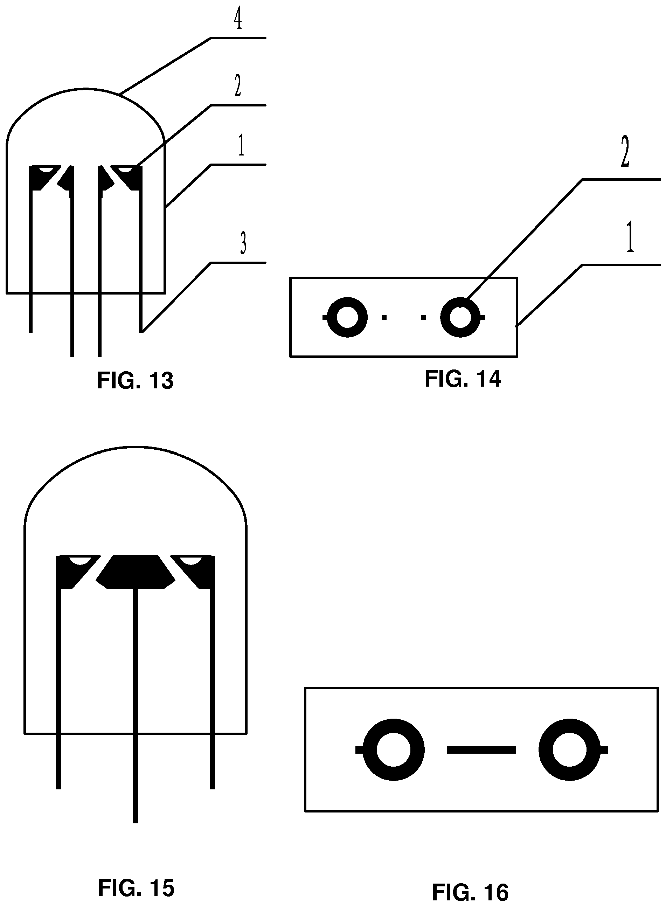

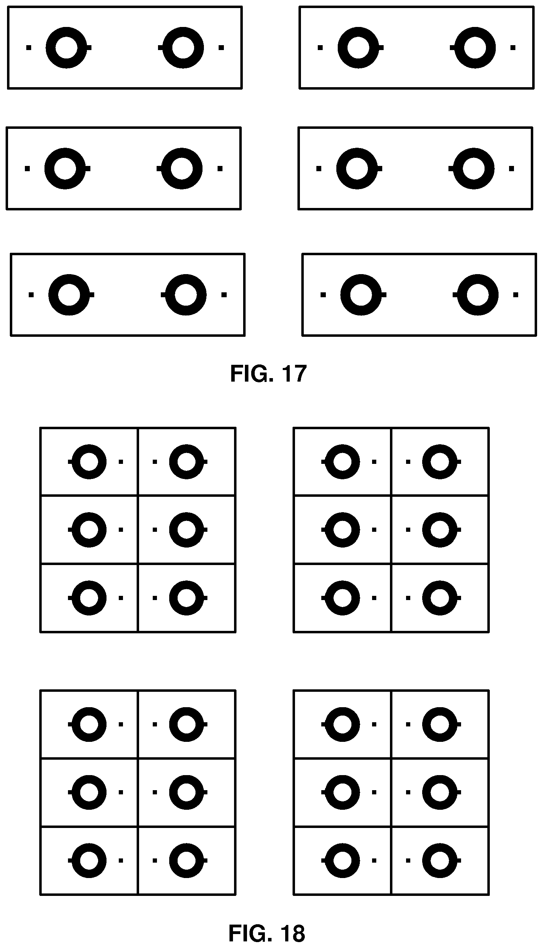

As shown in FIGS. 9-22, the light-emitting pixel is the light-emitting tube that comprises a cylindrical lens 4, a capsule 1, a pin 3, and a light-emitting chip 2. The light-emitting chip 2 is disposed inside the capsule 1, the cylindrical lens 4 is disposed on one side of the capsule 1, and the pin 3 is arranged on the other side of the capsule 1. The pin 3 is connected to the light-emitting chip 2. FIG. 3 indicates the origin of the name of the cylindrical lens, that is, a cylindrical surface of the light-emitting tube or the light-emitting pixel is yielded by collecting a lamina from a row of the cylindrical lens plate, so that a basic shape of the light-emitting pixel provided with the cylindrical lens is formed, as shown in FIG. 4. A corresponding surface of the cylindrical lens 4 arranged on the capsule 1 is a cylindrical surface, a concaved cylindrical surface, or a convex cylindrical surface. A surface mounted device (SMD) has the same corresponding features.

A side of the cylindrical lens in a longitudinal section of the light-emitting pixel is a straight line, as shown in FIG. 4, a convex line, as shown in FIG. 5, or a concave line, as shown in FIG. 6. FIGS. 5 and 6 are two deformations of cylindrical lens of the light-emitting tube of FIG. 4. A conventional light-emitting pixel comprising an ellipsoid lens or a spherical lens can be deformed according to the above principal, and can be manufactured by assembling two half parts of the light-emitting tube together, as shown in FIGS. 7 and 8. FIG. 8 is actually a special example of FIG. 7 that a horizontal radius is equal to a longitudinal radius. The light-emitting pixels of shapes shown in FIGS. 7-8, have cylindrical surface outlines in a longitudinal direction. Herein the light-emitting pixel having the side of the cylindrical lens in the longitudinal section being the straight line, as shown in FIG. 4, is described as the basic shape; and light-emitting pixels or light-emitting tubes having the side of the cylindrical lens in the longitudinal section being the convex line or the concave line, or having the ellipsoid lens or the spherical lens, as shown in FIGS. 5-8, are manufactured in accordance with the method for manufacturing the light-emitting pixel in FIG. 4. No matter what outline of the lens of the single element is, the large screen after being assembled basically has a cylindrical outline in a macro longitudinal direction.

The light-emitting tube of the ellipsoid lens can be variably designed to transform the light-emitting tube of the ellipsoid lens assembled by two half parts into a cylindrical lens or a cylindrical lens that has a deformation of a radial convex surface or a radial concave surface, as shown in FIG. 7. As a special design of the ellipsoid lens, two light-emitting tubes can be assembled to form a light-emitting tube of an ellipsoid lens, as shown in FIG. 8. As shown in FIGS. 4-8, no matter what shapes of the lens of the single element is, the large screen after being assembled by the elements basically has a cylindrical outline in the macro longitudinal direction.

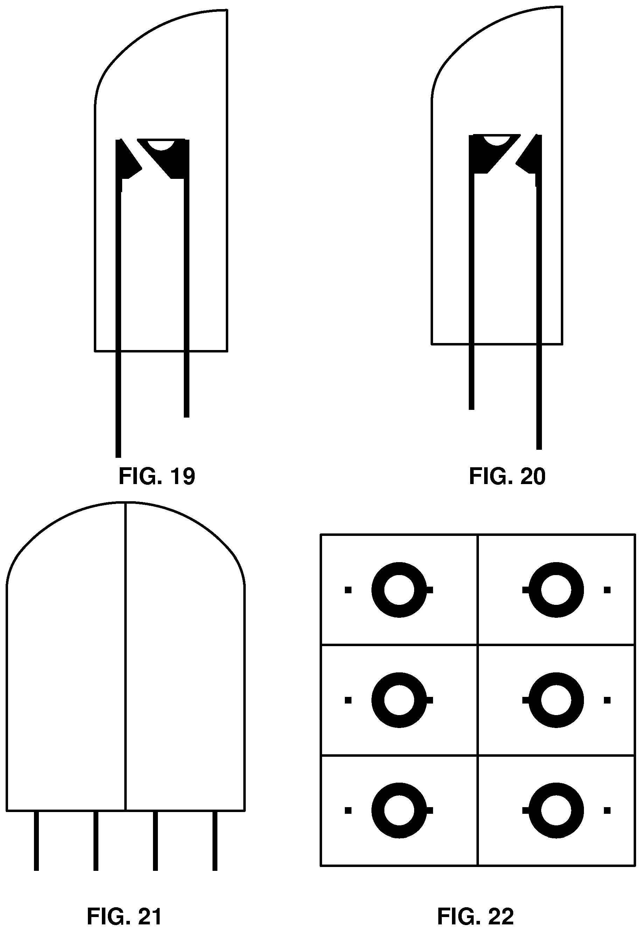

As shown in FIGS. 9-18, the light-emitting pixel adopts a single-colored light-emitting tube provided with a cylindrical lens, and the light-emitting tube comprises two light-emitting chips. One light-emitting chip operates to display the visual image information of the left eye, and the other light-emitting chip operates to display the visual image information of the right eye. The single-color herein indicates one of the three-primary colors (RGB). The light-emitting pixel is an integrated one having two light-emitting chips enclosed inside the capsule, the cylindrical lens is in a shape of a complete cylindrical surface. According to the invention the light-emitting pixel is two half parts divided from a complete light-emitting pixel and the two half parts are bilaterally symmetrical with each other; the two half parts are respectively manufactured for displaying the visual image for the left eye and the visual image for the right eye, as shown in FIGS. 19-20. FIGS. 21-22 shows an assembly diagram of the two half parts of the light-emitting pixel, and the two half parts are assembled during the manufacture of the circuit board.

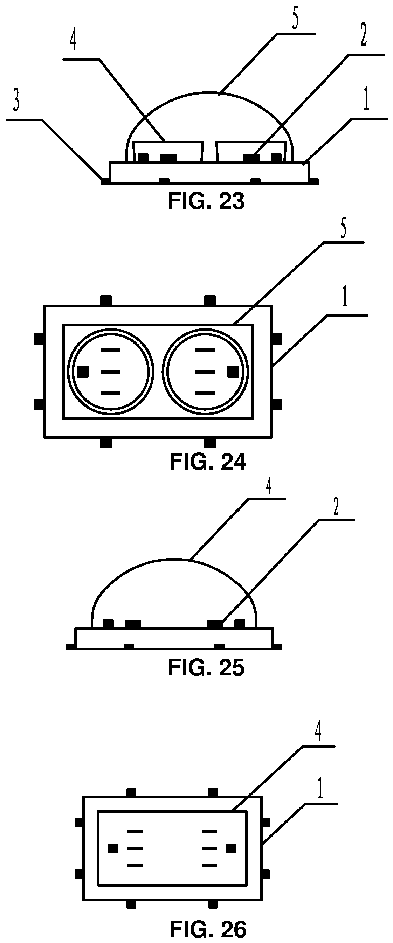

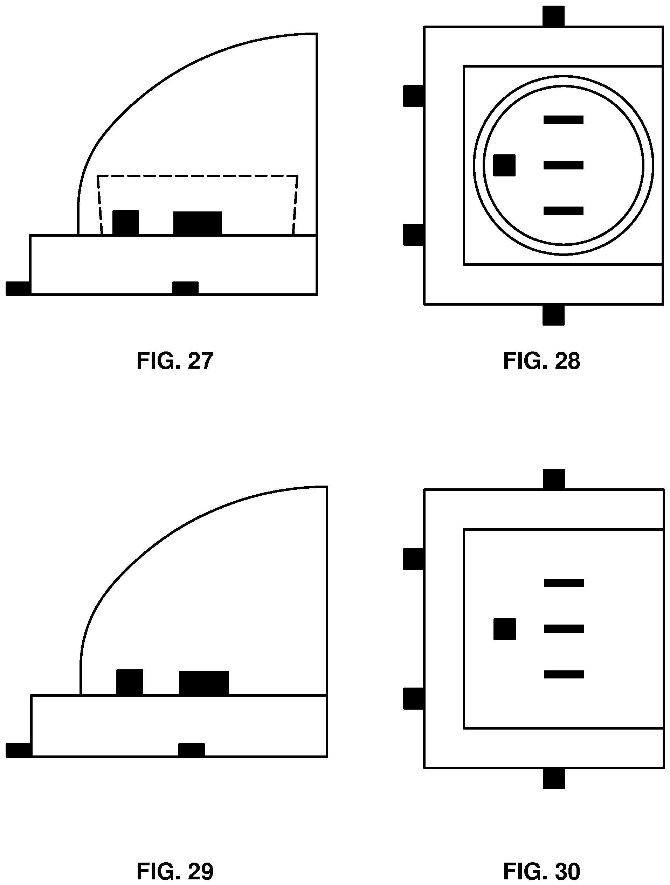

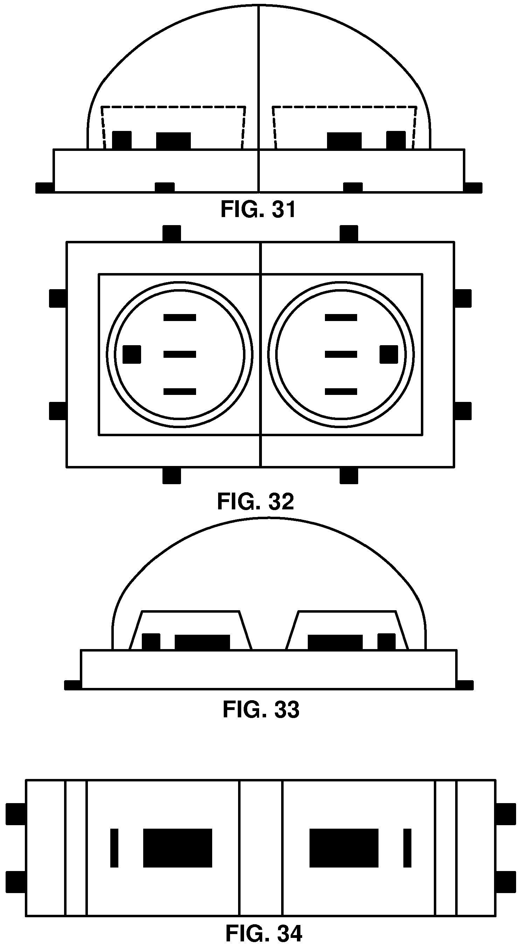

The light-emitting pixel can also be the SMD light-emitting pixel that comprises a lens being the cylindrical lens 4, as shown in FIGS. 23-24, two three-in-one SMD light-emitting pixels are assembled together and is further enclosed by the cylindrical cover based on the original enclosed structures. As shown in FIGS. 25-26, two three-in-one (comprising the three primary colors RGB) SMD light-emitting pixels of the cylindrical lens are manufactured together, and the cylindrical lens 4 directly encloses the capsule 1. Or the cylindrical cover is arranged on the light-emitting surface of the capsule 1 of the SMD light-emitting pixel while other structures remain the same, as shown in FIGS. 27-30, the light-emitting pixel is divided into two half parts that are bilaterally symmetrical with each other for displaying the visual image of the left eye and the visual image for the right eye. These two half parts are separately produced and assembled together during the manufacture of the circuit board, as shown in FIGS. 31-34.

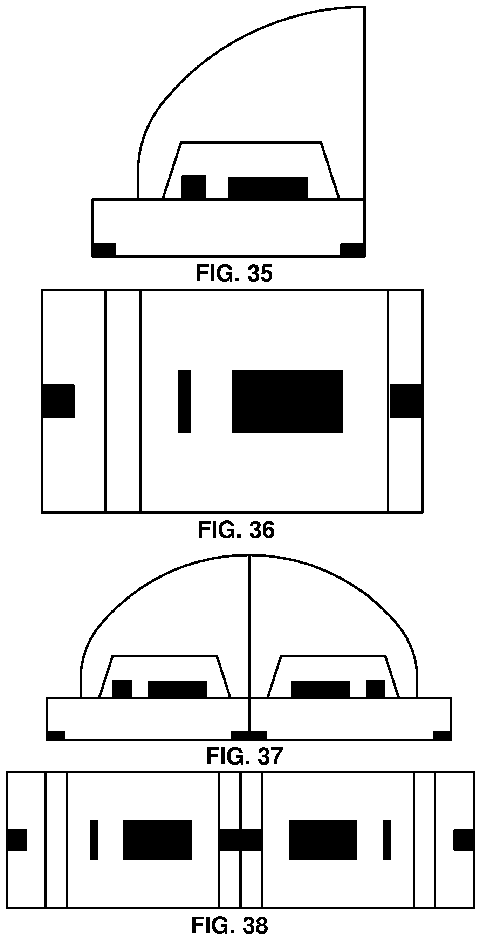

As shown in FIGS. 35-36, SMD light-emitting pixel is a single colored SMD light-emitting tube provided with the cylindrical lens, or two separate single colored SMD light-emitting tubes of the cylindrical lens are assembled together, as shown in FIGS. 37-38, to form a complete cylindrical lens.

The invention is further illustrated by detailed description of the illustrative examples combined with the drawings.

As shown in FIGS. 1 and 2, for a crystal or a plasma display screen, a cylindrical lens plate is arranged in front of the screen for realizing a naked-eye stereoscopic display. Such a cylinder lens is shown in FIG. 1, which comprises light-emitting pixels 1 for the right eye and the left eye and the cylindrical lens plate 2. The display principle of the crystal or the plasma display screen is different from that of the large screen, so when applying the light-emitting principle of the crystal or the plasma display screen to the LED large screen, a cylindrical-like lens plate is required to be arranged in front of the LED large screen, as shown in FIG. 2, serious reflection occurs on the cylindrical lens plate, thereby largely decreasing the contrast and the color saturation of the display screen.

The large stereoscopic screen comprises a control device and a display screen. The display screen comprises a plurality of light-emitting pixels (also called light-emitting points) controlled by the control device. Each of the light-emitting pixels is provided with the cylindrical lens, respectively. The large screen comprising such light-emitting pixels emits light of right visual image and left visual image perceived by the right eye and the left eye, respectively, to form a difference between visual images perceived by the left eye and the right eye according to the light-emitting principle of the cylindrical lens, and finally form a stereoscopic image in human brain. People are not required to wear a pair of stereoscopic glasses so that the naked-eye stereoscopic large screen display is realized. A periphery of each light-emitting point or each light-emitting pixel is treated by different kinds of black matrix, including but not limited to, a black plastic frame, for increasing the contrast and the color saturation.

As shown in FIGS. 9-22, the light-emitting pixel is the light-emitting tube that comprises a cylindrical lens 4, a capsule 1, a pin 3, and a light-emitting chip 2. The light-emitting chip 2 is disposed inside the capsule 1, the cylindrical lens 4 is disposed on one side of the capsule 1, and the pin 3 is arranged on the other side of the capsule 1. The pin 3 is connected to the light-emitting chip 2. FIG. 3 indicates the origin of the name of the cylindrical lens, that is, a cylindrical surface of the light-emitting tube or the light-emitting pixel is yielded by collecting a lamina from a row of the cylindrical lens plate, so that a basic shape of the light-emitting pixel provided with the cylindrical lens is formed, as shown in FIG. 4. A corresponding surface of the cylindrical lens 4 arranged on the capsule 1 is a cylindrical surface, a concaved cylindrical surface, or a convex cylindrical surface. A surface mounted device (SMD) has the same corresponding features.

A side of the cylindrical lens in a longitudinal section of the light-emitting pixel is a straight line, as shown in FIG. 4, a convex line, as shown in FIG. 5, or a concave line, as shown in FIG. 6. FIGS. 5 and 6 are two deformations of cylindrical lens of the light-emitting tube of FIG. 4. A conventional light-emitting pixel comprising an ellipsoid lens or a spherical lens can be deformed according to the above principal, and can be manufactured by assembling two half parts of the light-emitting tube together, as shown in FIGS. 7 and 8. FIG. 8 is actually a special example of FIG. 7 that a horizontal radius is equal to a longitudinal radius. The light-emitting pixels of shapes shown in FIGS. 7-8, have cylindrical surface outlines in a longitudinal direction. Herein the light-emitting pixel having the side of the cylindrical lens in the longitudinal section being the straight line, as shown in FIG. 4, is described as the basic shape; and light-emitting pixels or light-emitting tubes having the side of the cylindrical lens in the longitudinal section being the convex line or the concave line, or having the ellipsoid lens or the spherical lens, as shown in FIGS. 5-8, are manufactured in accordance with the method for manufacturing the light-emitting pixel in FIG. 4. No matter what outline of the lens of the single element is, the large screen after being assembled basically has a cylindrical outline in a macro longitudinal direction.

The light-emitting tube of the ellipsoid lens can be variably designed to transform the light-emitting tube of the ellipsoid lens assembled by two half parts into a cylindrical lens or a cylindrical lens that has a deformation of a radial convex surface or a radial concave surface, as shown in FIG. 7. As a special design of the ellipsoid lens, two light-emitting tubes can be assembled to form a light-emitting tube of an ellipsoid lens, as shown in FIG. 8. As shown in FIGS. 4-8, no matter what shapes of the lens of the single element is, the large screen after being assembled by the elements basically has a cylindrical outline in the macro longitudinal direction.

As shown in FIGS. 9-18, the light-emitting pixel adopts a single-colored light-emitting tube provided with a cylindrical lens, and the light-emitting tube comprises two light-emitting chips. One light-emitting chip operates to display the visual image information of the left eye, and the other light-emitting chip operates to display the visual image information of the right eye. The single-color herein indicates one of the three-primary colors (RGB). The light-emitting pixel is an integrated one having two light-emitting chips enclosed inside the capsule, the cylindrical lens is in a shape of a complete cylindrical surface. According to the invention the light-emitting pixel is two half parts divided from a complete light-emitting pixel and the two half parts are bilaterally symmetrical with each other; the two half parts are respectively manufactured for displaying the visual image for the left eye and the visual image for the right eye, as shown in FIGS. 19-20. FIGS. 21-22 shows an assembly diagram of the two half parts of the light-emitting pixel, and the two half parts are assembled during the manufacture of the circuit board.

The light-emitting pixel can also be the SMD light-emitting pixel that comprises a lens being the cylindrical lens 4, as shown in FIGS. 23-24, two three-in-one SMD light-emitting pixels are assembled together and is further enclosed by the cylindrical cover based on the original enclosed structures. As shown in FIGS. 25-26, two three-in-one (comprising the three primary colors RGB) SMD light-emitting pixels of the cylindrical lens are manufactured together, and the cylindrical lens 4 directly encloses the capsule 1. Or the cylindrical cover is arranged on the light-emitting surface of the capsule 1 of the SMD light-emitting pixel while other structures remain the same, as shown in FIGS. 27-30, the light-emitting pixel is divided into two half parts that are bilaterally symmetrical with each other for displaying the visual image of the left eye and the visual image for the right eye. These two half parts are separately produced and assembled together during the manufacture of the circuit board, as shown in FIGS. 31-34.

As shown in FIGS. 35-36, SMD light-emitting pixel is a single colored SMD light-emitting tube provided with the cylindrical lens, or two separate single colored SMD light-emitting tubes of the cylindrical lens are assembled together, as shown in FIGS. 37-38, to form a complete cylindrical lens.

While particular embodiments of the invention have been shown and described, it will be obvious to those skilled in the art that changes and modifications may be made without departing from the invention as defined in the appended claims.

### Industrial applicability

The invention provides a large stereoscopic screen comprising a cylindrical lens. The cylindrical lens is disposed on one side of a light-emitting point or a light-emitting pixel of the screen. Thus, the screen comprising the light-emitting points or the light-emitting pixels transmits light of a left image and a right image to the left eye and the right eye, respectively, to form a difference between visual images perceived by the left eye and the right eye in correspondence with the light-emitting principal of the cylindrical lens, whereby producing a stereoscopic image in the human brain. People are not required to wear a pair of stereoscopic glasses so that the naked-eye stereoscopic large screen display is realized. Hence, the invention has the industrial applicability.

## Claims

1. A stereoscopic screen, comprising:
a) a control device; and
b) a display screen, the display screen comprising a plurality of light-emitting pixels;
**characterized in that**
each of the plurality of light-emitting pixels comprises a first unit and a second unit;
the first unit and the second unit are bilaterally symmetrical to each other;
the first unit comprises a first cylindrical lens, a first capsule (1), a first pin (3), and a first light-emitting chip (2);
the first light-emitting chip (2) is disposed inside the first capsule (1);
the first cylindrical lens is disposed on the first capsule (1);
the first pin (3) is connected to the first light-emitting chip (2); the second unit comprises a second cylindrical lens, a second capsule, a second pin, and a second light-emitting chip;
the second light-emitting chip is disposed inside the second capsule;
the second cylindrical lens is disposed on the second capsule;
the second pin is connected to the second light-emitting chip;
the first pin (3) and the second pin are connected to the control device;
the first cylindrical lens (4) and the second cylindrical lens form a complete cylindrical lens;
the first light-emitting chip (2) has a single light color selected from the three-primary colors (RGB); and
the second light-emitting chip has a single light color selected from the three-primary colors (RGB).

2. The stereoscopic screen of claim 1, **characterized in that** the first unit and the second unit are disposed next to each other.

3. The stereoscopic screen of claim 1, **characterized in that** the control device operates the first light-emitting chip (2) to display image information for the left eye; and
the control device operates the second light-emitting chip to display image information for the right eye.

## Patentansprüche

1. Stereoskopischer Bildschirm, umfassend:
a) eine Steuervorrichtung; und
b) einen Bildschirm, wobei der Bildschirm eine Vielzahl von lichtemittierenden Pixeln umfasst;
**dadurch gekennzeichnet, dass**
jedes von der Vielzahl von lichtemittierenden Pixeln eine erste Einheit und eine zweite Einheit umfasst;
die erste Einheit und die zweite Einheit bilateral symmetrisch zueinander sind;
die erste Einheit eine erste zylindrische Linse, eine erste Kapsel (1), einen ersten Stift (3) und einen ersten lichtemittierenden Chip (2) umfasst;
der erste lichtemittierende Chip (2) innerhalb der ersten Kapsel (1) angeordnet ist;
die erste zylindrische Linse auf der ersten Kapsel (1) angeordnet ist;
der erste Stift (3) mit dem ersten lichtemittierenden Chip (2) verbunden ist;
die zweite Einheit eine zweite zylindrische Linse, eine zweite Kapsel, einen zweiten Stift und einen zweiten lichtemittierenden Chip umfasst;
der zweite lichtemittierende Chip innerhalb der zweiten Kapsel angeordnet ist;
die zweite zylindrische Linse auf der zweiten Kapsel angeordnet ist;
der zweite Stift mit dem zweiten lichtemittierenden Chip verbunden ist;
der erste Stift (3) und der zweite Stift mit der Steuervorrichtung verbunden sind;
die erste zylindrische Linse (4) und die zweite zylindrische Linse eine vollständige zylindrische Linse bilden;
der erste lichtemittierende Chip (2) eine einzelne Lichtfarbe aufweist, die aus den drei Primärfarben (RGB) ausgewählt ist; und
der zweite lichtemittierende Chip eine einzelne Lichtfarbe aufweist, die aus den drei Primärfarben (RGB) ausgewählt ist.

2. Stereoskopischer Bildschirm nach Anspruch 1, **dadurch gekennzeichnet, dass**
die erste Einheit und die zweite Einheit nebeneinander angeordnet sind.

3. Stereoskopischer Bildschirm nach Anspruch 1, **dadurch gekennzeichnet, dass**
die Steuervorrichtung den ersten lichtemittierenden Chip (2) betreibt, um Bildinformationen für das linke Auge anzuzeigen; und
die Steuervorrichtung den zweiten lichtemittierenden Chip betreibt, um Bildinformationen für das rechte Auge anzuzeigen.

## Revendications

1. Écran stéréoscopique, comprenant :
a) un dispositif de commande ; et
b) un écran d'affichage, l'écran d'affichage comprenant une pluralité de pixels électroluminescents ;
**caractérisé en ce que**
chacun de la pluralité de pixels électroluminescents comprend une première unité et une seconde unité ;
la première unité et la seconde unité sont bilatéralement symétriques l'une à l'autre ;
la première unité comprend une première lentille cylindrique, une première capsule (1), une première broche (3), et une première puce électroluminescente (2) ;
la première puce électroluminescente (2) est disposée à l'intérieur de la première capsule (1) ;
la première lentille cylindrique est disposée sur la première capsule (1) ;
la première broche (3) est raccordée à la première puce électroluminescente (2) ;
la seconde unité comprend une seconde lentille cylindrique, une seconde capsule, une seconde broche, et une seconde puce électroluminescente ;
la seconde puce électroluminescente est disposée à l'intérieur de la seconde capsule ;
la seconde lentille cylindrique est disposée sur la seconde capsule ;
la seconde broche est raccordée à la seconde puce électroluminescente ;
la première broche (3) et la seconde broche sont raccordées au dispositif de commande ;
la première lentille cylindrique (4) et la seconde lentille cylindrique forment une lentille cylindrique complète ;
la première puce électroluminescente (2) a une seule couleur de lumière sélectionnée parmi les trois couleurs primaires (RVB) ; et
la seconde puce électroluminescente a une seule couleur de lumière sélectionnée parmi les trois couleurs primaires (RVB).

2. Écran stéréoscopique selon la revendication 1, **caractérisé en ce que**
la première unité et la seconde unité sont disposées à proximité l'une de l'autre.

3. Écran stéréoscopique selon la revendication 1, **caractérisé en ce que**
le dispositif de commande actionne la première puce électroluminescente (2) pour afficher des informations d'image pour l'œil gauche ; et
le dispositif de commande actionne la seconde puce électroluminescente pour afficher des informations d'image pour l'œil droit.
